# EUROPEAN PATENT APPLICATION

(11) **EP 2 645 442 A2**
(43) Date of publication of application: **02.10.2013**
(21) Application number: 13161324.2
(22) Date of filing: 27.03.2013
(51) Int. Cl.: H01L 51/44, H01L 51/52

(54) **Multiple light management textures**

(30) Priority: 27.03.2012 IN DE08912012
(71) Applicant: Moser Baer India Ltd., 110020 New Delhi (IN)
(72) Inventor: Peters, Patrick, Canandaigua, NY 14424 (US)
(74) Representative: Beck & Rössig European Patent Attorneys

(57) **Abstract**

An optoelectronic device (100) providing improved light management is provided. The optoelectronic device (100) includes a substrate (102, 202) having a substantially flat surface, a light management layer (104) provided on the flat surface, such that the light management layer (104) includes a first light management texture (212). The optoelectronic device (100) also includes a planarization layer (106, 216) on the first light management texture (212). The planarization layer (106, 216) has a top surface that is defined by a first portion and a second portion, such that the first portion is a substantially flat surface and the second portion includes a second light management texture (214) corresponding to the first light management texture (212). Further, the second light management texture (214) has dimensions relatively less than that of the first light management texture (212) and the first light management texture (212) and the second light management texture (214) enable light management in a waveguide mode and a surface plasmon polariton (SPP) mode respectively. The optoelectronic device (100) also includes a functional stack (108) over the planarization layer (106, 216), such that the second light management texture (214) propagates into the functional stack (108).

## Description

The invention disclosed herein relates, in general, to optoelectronic devices. More specifically, the present invention relates to light management textures for improving the light management efficiency of the optoelectronic devices.

In functioning of optoelectronic devices like the Organic Light Emitting Devices (OLEDs) and Thin-Film Photovoltaic Cells (TF-PVs), light management is a very critical aspect that substantially affects the efficiency of such devices.

In OLEDs, roughly 80% of the emitted light is lost at various interfaces such as a substrate-ambient medium interface, layers interface, the cathode layer interface, etc. Light trapped within layers of the OLED or the substrate is commonly known as waveguide mode of light trapping. Similarly, the light trapped at a surface of a cathode layer is commonly known as surface plasmon polariton mode. Light trapped via these modes needs to be extracted to improve the efficiency of the OLEDs.

For example, internal or external light extraction texture can be used at OLED stack layers - substrate interfaces, to change the path of light in order to enable extraction in the waveguide mode. For surface plasmon polariton (SPP) mode, the light extraction texture needs to propagate into cathode layer for effective light extraction. At the same time, dimensions of the textures for SPP mode needs to be much smaller in comparison to the internal or external light extraction texture, else device failure, device cracking and other similar problems can occur.

However, reducing the dimensions adversely affects light extraction in waveguide mode. Therefore, to effectively and optimally extract light in both modes different textures are required, which are not only difficult to manufacture but also need careful optimization with respect to the OLED functional layers.

In light of the above discussion, there is a need to effectively extract light in both the modes simultaneously.

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.
FIG. 1 is a diagrammatic illustration of various components of an exemplary optoelectronic device, in accordance with an embodiment of the present invention;
FIG. 2a is a diagrammatic illustration depicting trapping of light in an optoelectronic device, in accordance with the state of the art;
FIGs. 2b and 2c are diagrammatic illustrations depicting functionality enabled by a first light management texture and a second light management texture of an optoelectronic device, respectively, in accordance with an embodiment of the present invention;
FIGs. 3a and 3b are diagrammatic illustrations of structure of the first light management texture and the second light management texture of an optoelectronic device, in accordance with two exemplary embodiments of the present invention;
FIG. 3c is a diagrammatic illustration of a magnified view a structure of the second light management texture of the optoelectronic device of FIG. 3b, in accordance with exemplary embodiments of the present invention; and
FIGs. 4a, 4b, 4c, 4d, 4e, 4f, 4g and 4h are diagrammatic illustrations of the first light management texture and the second light management texture of an optoelectronic device, in accordance with exemplary embodiments of the present invention.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

The instant exemplary embodiments provide an improved optoelectronic device that provides highly effective light management.

The instant exemplary embodiments provide an improved optoelectronic device that provides light management in both waveguide mode and surface plasmon polariton mode.

Some embodiments of the present invention provide an optoelectronic device. The optoelectronic device includes a substrate having a substantially flat surface, a light management layer provided on the flat surface, such that the light management layer includes a first light management texture. The optoelectronic device also includes a planarization layer on the first light management texture. The planarization layer has a top surface that is defined by a first portion and a second portion, such that the first portion is a substantially flat surface and the second portion includes a second light management texture corresponding to the first light management texture. Further, the second light management texture has dimensions relatively less than that of the first light management texture and the first light management texture and the second light management texture enable light management in a waveguide mode and a surface plasmon polariton (SPP) mode respectively or simultaneously. The optoelectronic device also includes a functional layer stack over the planarization layer, such that the second light management texture propagates into the functional layer stack.

Some embodiments of the present invention provide an optoelectronic device. The optoelectronic device is structures such that the device includes a stack of a substrate a light management layer having a first light management texture, a planarization layer on the first light management texture including a second light management texture corresponding to the first light management texture. Further, the second light management texture is designed such to have dimensions relatively less than that of the first light management texture. Furthermore, the first light management texture and the second light management texture enable the optoelectronic device to provide light management in a waveguide mode and a surface plasmon polariton (SPP) mode respectively.

Before describing the present invention in detail, it should be observed that the present invention utilizes apparatus components related to an optoelectronic device such as an organic light emitting device. Accordingly the apparatus components have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

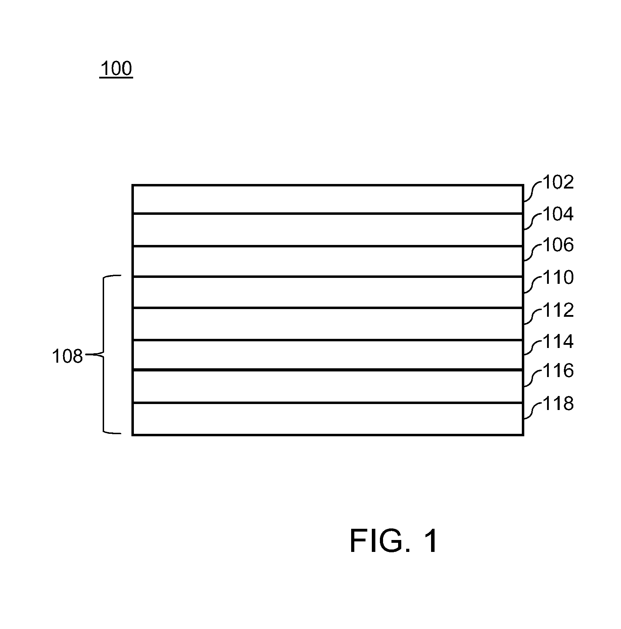

Referring now to the drawings, there is shown in FIG. 1, an exemplary optoelectronic device 100, in accordance with an embodiment of the present invention. Examples of the optoelectronic device 100 include an Organic Light Emitting Diode (OLED) or a thin-film photovoltaic device (TF-PV).

Some real life examples of an OLED can include, but are not limited to, White Organic Light Emitting Diode (W-OLED), Active-matrix Organic Light Emitting Diodes (AMOLED), Passive-matrix Organic Light Emitting Diodes (PMOLED), Flexible Organic Light Emitting Diodes (FOLED), Stacked Organic Light Emitting Diodes (SOLED), Tandem Organic Light Emitting Diode, Transparent Organic Light Emitting Diodes (TOLED), Top Emitting Organic Light Emitting Diode, Bottom Emitting Organic Light Emitting Diode, Fluorescence doped Organic Light Emitting Diode (FOLED) and Phosphorescent Organic Light Emitting Diode (PHOLED).

Similarly, examples of a TF-PV can include, but are not limited to, a thin film solar cell, an organic solar cell, an amorphous silicon solar cell, a microcrystalline silicon solar cell, a micromorph silicon tandem solar cell, a Copper Indium Gallium Selenide (CIGS) solar cell, a Cadmium Telluride (CdTe) solar cell, and the like.

For the purpose of the description, the optoelectronic device 100 illustrated here has been shown to include only those layers that are pertinent to the description of the invention. However, it should be understood that the invention is not limited to the layers listed in the description here. In some cases, the optoelectronic device 100 may include additional layers to enhance efficiency or to improve reliability, without deviating from the scope of the invention.

The optoelectronic device 100 is shown to include a substrate 102, a lacquer layer 104, a planarization layer 106 and a functional layer stack 108. The functional layer stack 108 is configured to have one or more functional layers therein. The one or more functional layers include a first electrical contact 110, one or more organic layers 112 and 114, a second electrical contact 116 and a cover substrate 118.

The substrate 102 functions to provide strength to the optoelectronic device 100. Examples of material useful as the substrate include, but are not limited to, glass, flexible glass, polyethylene terephthalate (PET), polyethylene naphthalate (PEN), polycarbonate (PC) and other transparent or translucent material.

Moving on, the substrate 102 is also configured to receive and support the lacquer layer 104. It should be appreciated that the lacquer layer 104 may be interchangeably referred to as a light management layer during the description of the invention. The lacquer layer 104 is generally made up of a curable material and is provided over the substrate 102. The lacquer layer 104 can be provided on the substrate 102 by using a brush or roller, dispensing, screen printing, slot dye coating, spin-coating, spray coating, diverse replication techniques, or even printing. The curable material has a property to retain any light management texture embossed on it when it is cured by using mediums such as heat or light. The curable material can include, but is not limited to, a ultra-violet curable material, a photo-polymer lacquer, an acrylate, and silica or silica-titania based sol-gel materials. In some embodiments, a texture may also be applied to the lacquer layer 104 by use of photolithographic techniques.

In some embodiments, the curable material is post-cured by using light and/or heat after imprinting of a first light management texture on the curable material on the substrate 102. Post-curing of the curable material is performed in order to minimize the out-gassing of fluids or solvents from the curable material during later stages of manufacturing of the optoelectronic device 100 or during actual usage of the optoelectronic device 100. These fluids or solvents coming out of the curable material have a tendency to contaminate subsequent layers of the optoelectronic device 100 and thus, impact the overall performance of the optoelectronic device 100.

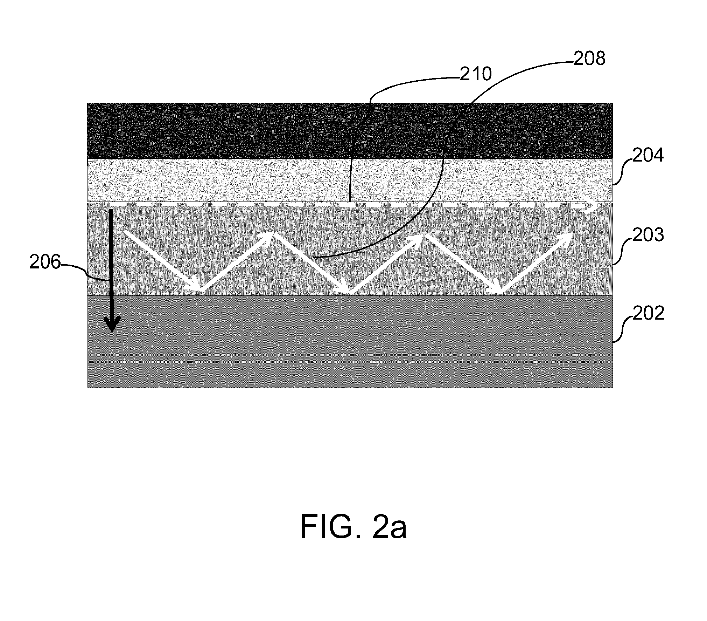

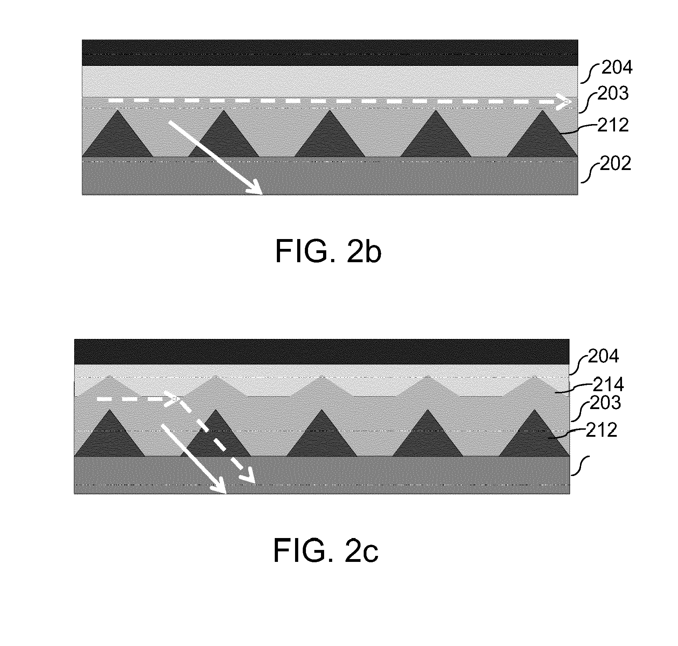

In accordance with the present invention, the lacquer layer 104 is deposited in a manner such that the first light management texture can be provided on a surface of the lacquer layer 104. The examples of the first light management texture include, but are not limited to, 1D or 2D periodic U-shaped features, a 1D or 2D periodic sinusoidal grating, 1D or 2D periodic upright or inverted pyramids, random upright or inverted pyramids, 1D or 2D periodic inverted cones, and other micro and nano-sized structures. The first light management texture facilitates light management in the optoelectronic device 100. The design and structure of the lacquer layer 104 and the first light management texture will be further described in conjunction with FIGs. 2a, 2b and 2c.

Moving on to the planarization layer 106, the planarization layer 106 is defined by a top surface and a bottom surface such that the bottom surface substantially mates with the first light management texture on the lacquer layer 104. Further, the top surface is designed to include at least a first portion and a second portion, such that the first portion is defined by a substantially flat surface, and the second portion is defined by a second light management texture corresponding to the first light management texture.

In an embodiment, the planarization layer 106 functions to cover and protect the first light management texture from undergoing deformation or fouling during later stages of manufacturing of the optoelectronic device 100. Examples of material for use as the planarization layer 106 include UV curing acrylates, thermal curing epoxies, sol-gel materials, hard-coats, and airogels. Further, the material used as the planarization layer 106 is highly transparent and exhibits low light absorption. The design and structure of the planarization layer 106 and the second light management texture will be further described in conjunction with FIGs. 2a, 2b and 2c.

Once the planarization layer 106 has been deposited, the first electrical contact 110 is provided over the lacquer layer 104. In an embodiment, the first electrical contact 110 can be implemented using a transparent conducting oxide (TCO). TCOs are doped metal oxides, examples of TCOs include, but are not limited to, Zinc Oxide, Tin Oxide, Aluminum-doped Zinc Oxide (AZO), Boron doped Zinc Oxide (BZO), Gallium doped Zinc Oxide (GZO), Fluorine doped Tin Oxide (FTO), Indium Zinc Oxide and Indium doped Tin Oxide (ITO). TCOs have more than 80% transmittance of incident light and have conductivities higher than 10³ S/cm for efficient carrier transport. The transmittance of TCOs, just as in any transparent material, is limited by light scattering at defects and grain boundaries. In another embodiment, the first electrical contact 110 can also be implemented with a PEDOT-PSS, or any other transparent polymers, or thin metal layers.

The first electrical contact 110 may be deposited by processes such as Physical Vapor Deposition (PVD), Low Pressure Chemical Vapor Deposition (LPCVD), Atmospheric Pressure Chemical Vapor Deposition (APCVD), or even Plasma Enhanced Chemical Vapor Deposition (PECVD) and the like.

Moving on to the next set of layers, the one or more organic layers 112 and 114. Generally, the one or more organic layers 112 and 114 are deposited using methods such as dip coating, spin coating, doctored blade, spray coating, screen printing, sputtering, glass mastering, photoresist mastering, all kinds of CVD, electroforming, and evaporation. In an embodiment, the one or more organic layers 112 and 114 can be implemented with any organic electroluminescent material such as a light-emitting polymer, evaporated small molecule materials, light-emitting dendrimers or molecularly doped polymers. For the purpose of this description, the organic layers are shown to include only two layers, however, it will be readily apparent to those skilled in the art that the optoelectronic device 100 can include or exclude one or more organic layers without deviating from the scope of the invention.

Following the one or more organic layers 112 and 114, the second electrical contact 116 is deposited. In one embodiment, the second electrical contact 116 can includes a second layer of TCO, a layer of silver, and a layer of aluminum. In other embodiments, the second electrical contact 116 can be implemented with metals with appropriate work function to make injection of charge carriers, for example, calcium, aluminum, gold, and silver. In an embodiment, the first electrical contact 110 and the second electrical contact 116 act as electrode layers. For example the first electrical contact 110 acts as an anode and the second electrical contact 116 acts as a cathode. Thereafter, all the above mentioned layers are encapsulated using a cover substrate 118 between the substrate 102 and the cover substrate 118.

Usually, efficiency of the optoelectronic devices is governed by light management in the optoelectronic device. Light management is a very critical aspect substantially affecting the efficiency of such devices. For example, in OLEDs, difference in refractive indices of ambient medium, substrate and deposited organic layers can significantly reduce the percentage of generated light that can be extracted. Similarly in a TF-PV device, light trapping is a major factor affecting its efficiency by increasing a path of light in the TF-PV device thereby increasing its absorption.

For example, the problem associated with efficient light management has been illustrated using FIG. 2a. For example, most of the light produced in an OLED is trapped by internal reflection in a high refractive index stack 203 of the one or more organic layers and the first electrical contact's interface with a substrate 202. This is because the stack 203 has higher indexes of refraction than the substrate 202. It should be appreciated that the stack 203 is similar in characteristics to the one or more organic layers 112 and 114 and the first electrical contact 110 described in conjunction with FIG. 1. When a light is emitted by the organic layers of the OLED, it needs to pass through the substrate 202. It should be appreciated that the substrate 202 is similar in characteristics to the substrate 102 described in conjunction with FIG. 1.

However, when the light is incident from a high refractive index material onto an interface with a lower refractive index material, the light undergoes total internal reflection (TIR) for all incidence angles greater than the critical angle θc, defined by θc = sin⁻¹ (n2/n1), where n1 and n2 are the refractive indices of the high refractive index material and low refractive index material, respectively. Due to the same reason, when the light emitted by the one or more organic layers reaches an interface with the substrate 202, a substantial amount of light is reflected back into the OLED.

As shown in FIG. 2a, only radiated light in black emitted nearly perpendicular to the layers of the OLED can easily escape as depicted by the direction 206. Radiated light emitted away from perpendicular is un-likely to escape because of the TIR phenomenon described above. Depending on the direction of emission, the light may be trapped at an interface between the second electrical contact 204 and the high refractive index stack 203 of the one or more organic layers and the first electrical contact's interface with the substrate 202. Such light [illustrated by dotted white line 210] is referred herein as a surface plasmon polariton mode and light trapped within the high refractive index stack 203 (including the organic layers and the first electrical contact, usually TCO) [illustrated by solid white line 208] is referred herein as a waveguide mode. This light that is not emitted is ultimately absorbed within the OLED.

Light management in waveguide mode can be enabled by providing a first light management texture 212, as the first light management texture 212 is capable of changing propagation direction of the light at the interface between the organic layers, the TCO layer and the substrate. It should be appreciated that the first light management texture 212 is similar in characteristics to the first light management texture in the lacquer layer 104 described in conjunction with FIG. 1.

An exemplary illustration of enabling light management in waveguide mode has been depicted in FIG. 2b. The first light management texture 212 helps reducing the TIR of the light back into the optoelectronic device like the OLED. The first light management texture 212 may include geometries having dimensions in the order of the wavelength of the light to facilitate the change in propagation direction of the emitted light by diffraction. The first light management texture 212 may also include geometries having larger dimensions than the wavelength of the light to facilitate the change in propagation direction of the emitted light by refraction.

The first light management texture 212 can bring about a change in the light propagation direction by either diffraction or refraction. Usually, the first light management texture 212 having dimensions in the order of a wavelength of the light, change the light propagation direction by diffraction. Examples of the first light management texture 212 that change the light propagation direction by diffraction include, but are not limited to, a 1D grating and a 2D grating. The first light management texture 212 having dimensions larger than a wavelength of the light, usually change the light propagation direction by refraction. Examples of the first light management texture 212 that change the light propagation direction by refraction include, but are not limited to, a lens, a cone, and a pyramid. Preferably, the first light management texture 212 brings about a change in the light propagation direction by refraction. Also, preferably the dimensions of the first light management texture 212 are in the range of 200 nm to 1000 nm and periodicity of the first light management texture 212 is approximately 600 nm.

In an embodiment, the first light management texture is formed by using a stamper having a negative impression of the first light management texture 212. The stamper can be pressed into the substrate 202, while the substrate 202 is being heated above its deformation (glass transition) temperature. This step can be followed by a rapid cooling process to affix the first light management texture 212 on the substrate 202.

In yet another embodiment, a layer of a curable material, such as a photo-polymer lacquer or a sol-gel material can be applied onto the substrate 202 to form a lacquer layer and the first light management texture 212 is formed by imprinting or replicating impressions of the first light management texture 212 into the lacquer layer. For example, the layer of the curable lacquer material can be applied onto the substrate 202. Thereafter, a stamper can be contacted with the layer of curable lacquer, imprinting the first light management texture 212 to the lacquer layer. This can be followed by a curing process to affix the first light management texture 212 to the curable lacquer on the substrate 202. Examples of the curable material can include, but is not limited to, an ultra-violet curable material, a photo-polymer lacquer, an acrylate, and silica or silica-titania based sol-gel materials. However, it should be understood that the curable lacquer can be formed of any material having similar characteristics without deviating from the scope of the invention. In an embodiment, a refractive index of a material forming the first light management texture 212 is approximately 1.5. For example, if the texture is formed on the lacquer layer, then the material of the lacquer is so chosen that its refractive index is approximately 1.5.

Similarly, in case of a TF-PV device, the first light management texture 212 can provide light trapping function. The first light management texture 212 is provided in the TF-PV device to increase an optical path of the light transmitted in to the TF-PV device. The first light management texture 212 is such that it enables and enhances the light trapping capability of organic layers of the TF-PV. The first light management texture 212 helps in scattering and diffraction of the light and thus, enhances the light path through the TF-PV and hence, enhances the chance of absorption of light by the organic layers of the TF-PV. Therefore, the light management texture can also be called light trapping texture and as this light management texture is formed on the lacquer layer, therefore, the lacquer layer can be called light trapping layer in case of a TF-PV and similarly, the light management texture can be called light extraction texture and the corresponding lacquer layer can be called light extraction layer in case of an OLED.

The first light management texture 212 enables light extraction and light trapping in cases of an OLED and a TF-PV device respectively. The first light management texture 212 is usually micron or sub-micron sized textures that are preferably one of periodic and quasi-periodic in nature.

However, as depicted in FIG. 2b, radiated light shown in dotted white lines cannot escape as depicted using the first light management texture 212. Therefore to enable, light management in surface plasmon polariton mode, a second management texture 214 corresponding to the first light management texture 212 but having dimensions relatively less than the first light management texture 212 is provided. It should be appreciated that the second light management texture 214 is similar in characteristics to the second light management texture in the planarization layer 106 described in conjunction with FIG. 1.

Further, the second management texture 214 propagates into the first electrical contact layer 204. For instance a second management texture 214 illustrated in FIG. 2c with a periodicity of approximately 400 nm and dimensions in the range of 20 nm to 200 nm can enable light management in the surface plasmon polariton mode. As a result of presence of the second light management texture 214 the light depicted by the dotted white arrow is allowed to be emitted. It should be appreciated that dimensions of the second light management texture 214 enabling light management in the surface plasmon polariton mode has to be less than 100 nm. Higher dimensions may cause short circuit and open circuit defects in the optoelectronic device as the thin functional layer stack may not be able to follow topology of the second light management texture 214 resulting in cracks, interruptions and high functional layer stack thickness variations.

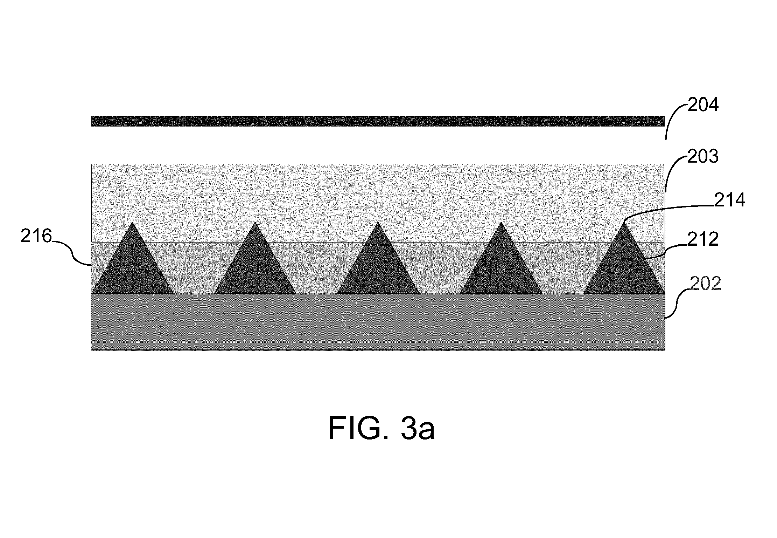

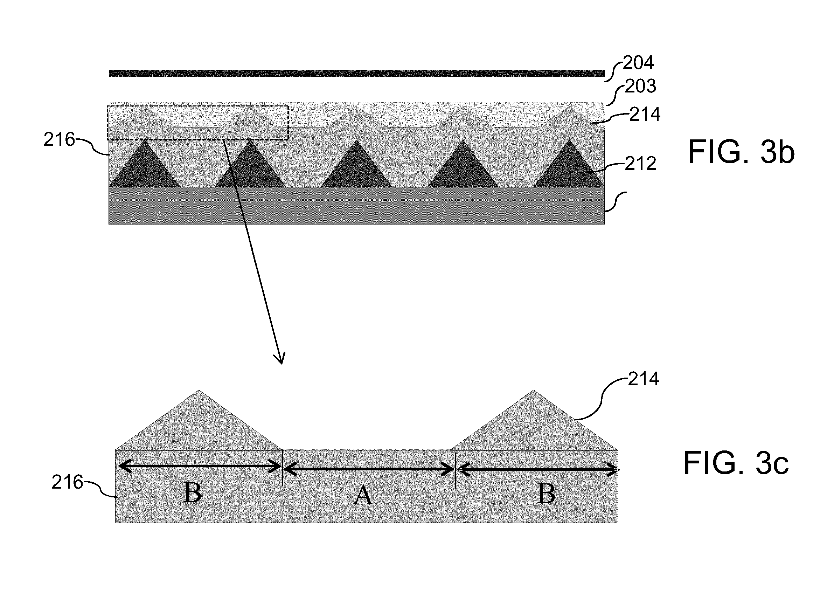

Exemplary illustration of the first management texture 212 and the second management texture 214, in accordance with two exemplary embodiments of the present invention has been illustrated with FIGs. 3a and 3b.

According to the invention, a planarization layer 216, similar in characteristic to the planarization layer 106 of FIG. 1, is deposited over the first management texture 212. As shown in FIG. 3a, the planarization layer 216 partially covers the first light management texture, thereby leaving a residual second light management texture 214 to propagate through the high refractive index stack 203 of the one or more organic layers and the first electrical contact. In another embodiment depicted in FIG. 3b, the planarization layer 216 can follow topology of the first light management texture 212 and as a result not be fully flat, leading to formation of a second management texture 214.

Moving on, there is also shown a magnified view in FIG. 3c of the boxed area in FIG. 3b. As shown, top surface of the planarization layer is defined by a first portion 'A' that substantially flat and a second portion 'B' that has the second light management texture 214. In an embodiment, the substantially flat portion 'A' of the planarization layer can include a third light management texture in addition to the second light management texture 214.

Further, a refractive index value of a material chosen for the planarization layer 216 is important in terms of emission of the light. In an embodiment, the refractive index of the material forming the planarization layer 216 should be equal to the refractive index of the high refractive index stack 203 of the one or more organic layers and the first electrical contact. In an embodiment, the refractive index of the planarization layer 216 can be approximately 1.7 to 1.9.

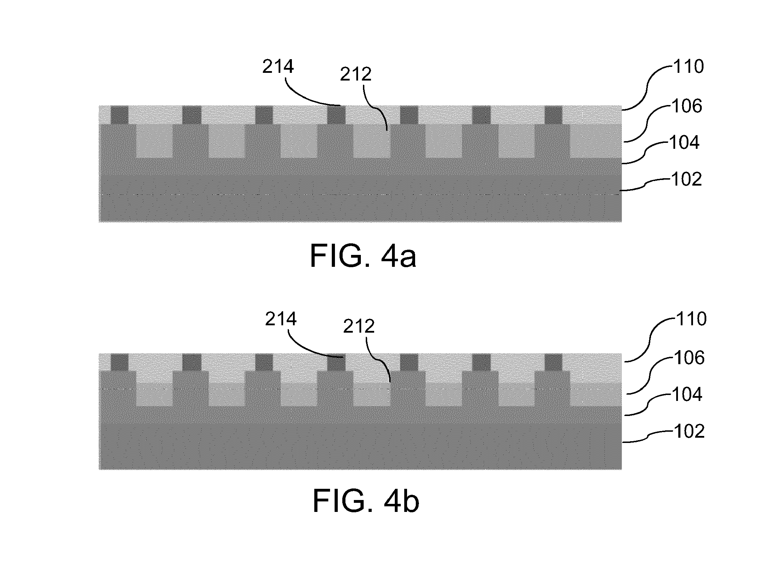

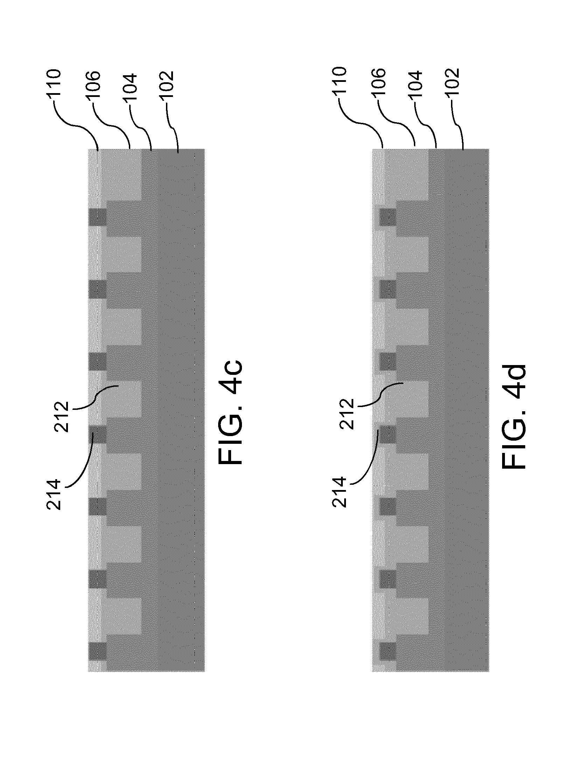

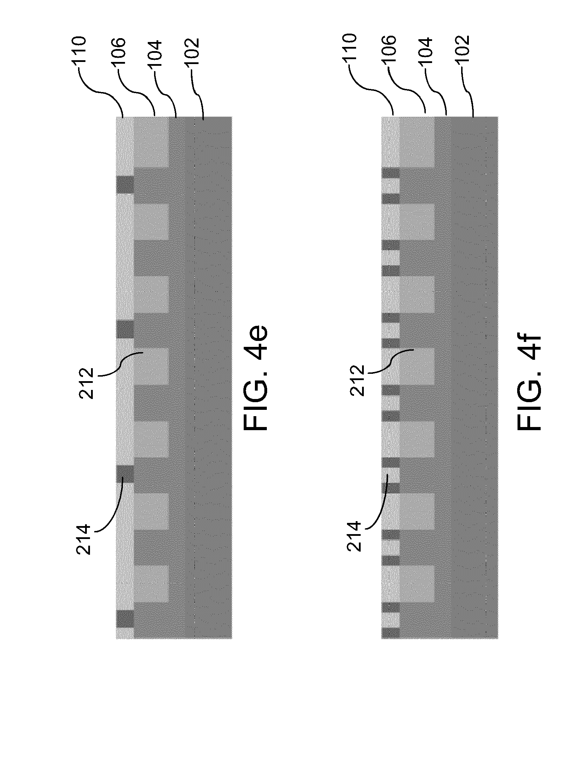

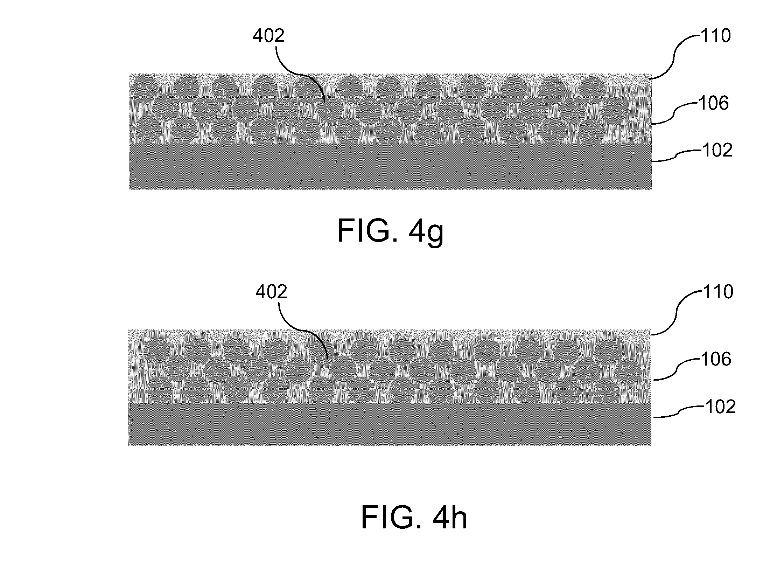

Further embodiments of the first light management texture and the second light management texture have been illustrated in FIGs. 4a, 4b, 4c, 4d, 4e, 4f, 4g and 4h. These embodiments depict the different variations possible with respect to depth, height and periodicity of the first light management texture and the second light management texture.

For example, in embodiments illustrated by FIGs. 4a and 4b, the optoelectronic device illustrated is shown to include the substrate 102, the lacquer layer 104, the planarization layer 106, the TCO layer 110, the first light management texture 212 and the second light management texture 214. As illustrated, in FIGs. 4a and 4b, the planarization layer 106 partially covers the first light management texture 212, thereby leaving a residual second light management texture 214. However, as illustrated, the invention provides the scope of varying heights of the first light management texture 212 and the second light management texture 214 by varying the height of the planarization layer 106 deposited.

Moving on, in embodiments illustrated by FIGs. 4c and 4d, the optoelectronic device illustrated is shown to include the substrate 102, the lacquer layer 104, the planarization layer 106, the TCO layer 110, the first light management texture 212 and the second light management texture 214. As illustrated, in FIGs. 4c, the planarization layer 106 partially covers the first light management texture 212, thereby leaving a residual second light management texture 214. However, in FIG. 4d, the invention the planarization layer 106 completely covers the first light management texture 212. This leads to the planarization layer 106 following a topology of the first light management texture 212 and resulting not being fully flat, leading to formation of a second management texture 214.

Moving on, in embodiments illustrated by FIGs. 4e and 4f, the optoelectronic device illustrated is shown to include the substrate 102, the lacquer layer 104, the planarization layer 106, the TCO layer 110, the first light management texture 212 and the second light management texture 214. As illustrated, in FIGs. 4e and 4f, the invention provides the scope of varying periodicity of the first light management texture 212 and the second light management texture 214. For example, in real life applications, different periodicity of the first light management texture 212 and the second light management texture 214 is required, with respect to accounting for different needs for light extraction in the waveguide mode and the surface plasma polariton mode.

In embodiments illustrated by FIGs. 4g and 4h, the planarization layer can include scattering particles 402. Further, the optoelectronic device illustrated is shown to include the substrate 102, the planarization layer 106, and the TCO layer 110. The presence of the scattering particles 402 can act as a substitute to the first light management texture and the second light management texture. Also, any angular colour shift problems may be reduced because of the presence of the scattering particles. Examples of materials of the scattering particles include, but are not limited to, TiO2 particles, ZrO2 particles, and the like. A texture of the layer formed by the scattering particles 402, arising from the physical properties of the lacquer and particles, can be partially planarized to function as described above. Also, it should be appreciated that in the scattering layer, several particle sizes may be present at the same time. Different particle sizes can be chosen, such that a first size of the scattering particles 402 may be chosen for optimized scattering, and a second size of the scattering particles 402 may be chosen for optimal formation of surface corrugation. This surface corrugation can propagate through the functional layers to harvest SPP modes.

Various embodiments, as described above, provide an optoelectronic device that has several advantages. The optoelectronic device according to the invention includes two light management textures, such that the two light management textures can enable light management in both waveguide mode and surface plasmon polariton mode. In case the second light management texture is not present, the light extraction in surface plasmon polariton mode is not possible. Further, in prior art combination of both the textures in a single device has not been possible, leading to at least partial losses in light management. These problems have been countered in the present invention by providing two light management textures in a single layer. Additionally, the refractive index of planarization layer is so chosen that there is no loss of efficiency in the optoelectronic device.

While the invention has been disclosed in connection with the preferred embodiments shown and described in detail, various modifications and improvements thereon will become readily apparent to those ordinarily skilled in the art. Accordingly, the spirit and scope of the present invention is not to be limited by the foregoing examples, but is to be understood in the broadest sense allowable by law.

All documents referenced herein are hereby incorporated by reference.

## Claims

1. An optoelectronic device (100) comprising at least:
a. a substrate (102, 202) having a substantially flat surface;
b. a light management layer (104) on said flat surface of said substrate (102, 202), said light management layer (104) having a first light management texture (212);
c. a planarization layer (106, 216) on said first light management texture (212), said planarization layer (106, 216) having a top surface defined by a first portion and a second portion; and
d. a functional stack (108) over said planarization layer, **characterized in that**
said first portion of said planarization layer (106, 216) is defined by a substantially flat surface, further wherein said second portion of said planarization layer (106, 216) is defined by a second light management texture (214) corresponding to said first light management texture (212), said second light management texture (214) having dimensions relatively less than that of said first light management texture (212), said first light management texture (212) and said second light management texture (214) enabling light management in a waveguide mode and a surface plasmon polariton (SPP) mode respectively; and wherein said second light management texture (214) propagates into said functional stack (108).

2. The optoelectronic device (100) of claim 1, wherein said planarization layer (106, 216) completely covers said first light management texture (212), whereby said second portion of said top surface of said planarization layer (106, 216) follows a contour of said first light management texture (212) to form said second light management texture (214).

3. The optoelectronic device (100) of claim 1, wherein said planarization layer (106, 216) partially covers said first light management texture (212), whereby said second portion of said top surface of said planarization layer (106, 216) is absent and enables at least a portion of said first light management texture (212) to protrude into said stack of functional layers and form said second light management texture (214).

4. The optoelectronic device (100) of one of claims 1 to 3, wherein a height of said first light management texture (212) ranges from 200 nm to 1000 nm.

5. The optoelectronic device (100) of one of claims 1 to 4, wherein a height of said second light management texture (214) ranges from 20 nm to 200 nm.

6. The optoelectronic device (100) of one of claims 1 to 5, wherein said first light management texture (212) and said second light management texture (214) is in form of scattering particles (402).

7. The optoelectronic device (100) of one of claims 1 to 6, wherein a third light management texture is provided on said substantially flat surface of said first portion of said top surface of said planarization layer (106, 216).

8. The optoelectronic device (100) of one of claims 1 to 7, wherein at least
a. a refractive index of said planarization layer (106, 216) is similar to a refractive index of said stack of functional layers; and
b. a refractive index of said light management layer (104) is similar to a refractive index of said substrate (102, 202).

9. The optoelectronic device (100) of one of claims 1 to 8, wherein said light management layer (104) is a light extraction layer when said optoelectronic device (100) is an organic light emitting device and said light management layer (104) is a light trapping layer when said optoelectronic device (100) is a photovoltaic device.

10. The optoelectronic device (100) of one of claims 1 to 9, wherein a periodicity of said first light management texture (212) and said second light management texture (214) is one of same and different.
